Europäisches Patentamt

European Patent Office

Office européen des brevets

(19)

(11) EP 0 752 175 B1

(12) EUROPÄISCHE PATENTSCHRIFT

(45) Veröffentlichungstag und Bekanntmachung des Hinweises auf die Patenterteilung:
**17.02.1999 Patentblatt 1999/07**

(21) Anmeldenummer: **95911220.2**

(22) Anmeldetag: **10.03.1995**

(51) Int Cl.[6]: **H03K 19/00**, H02M 3/07

(86) Internationale Anmeldenummer:
**PCT/DE95/00335**

(87) Internationale Veröffentlichungsnummer:
**WO 95/26077 (28.09.1995 Gazette 1995/41)**

(54) **VERLUSTARME INTEGRIERTE SCHALTUNG MIT REDUZIERTEM TAKTHUB**

LOW LOSS INTEGRATED CIRCUIT WITH REDUCED CLOCK SWING

CIRCUIT INTEGRE A FAIBLES PERTES A EXCURSION REDUITE DU SIGNAL D'HORLOGE

(84) Benannte Vertragsstaaten:
**DE FR GB IT**

(30) Priorität: **24.03.1994 DE 4410280**

(43) Veröffentlichungstag der Anmeldung:
**08.01.1997 Patentblatt 1997/02**

(73) Patentinhaber: **SIEMENS AKTIENGESELLSCHAFT
80333 München (DE)**

(72) Erfinder:
• **MEIER, Stefan
D-81739 München (DE)**
• **DE MAN, Erik
D-81739 München (DE)**

(56) Entgegenhaltungen:
**WO-A-92/09141          DE-A- 4 131 237
US-A- 4 563 600**

• **PATENT ABSTRACTS OF JAPAN vol. 14 no. 346 (E-956) [4289] ,26.Juli 1990 & JP,A,02 119427 (NEC IC MICROCOMPUT. SYST. LTD) 7.Mai 1990,**
• **ELECTRONICS & COMMUNICATIONS IN JAPAN, PART II - ELECTRONICS, Bd. 74, Nr. 4, April 1991 NEW YORK US, Seiten 91-101, SHIBATA ET AL 'energy transmission of switched-capacitor circuit and application to dc-dc converter'**

EP 0 752 175 B1

**Beschreibung**

Durch die ständig steigende Komplexität von ULSI-Schaltungen einerseits und die immer stärkere Anwendung derartiger Komponenten auch in Batterie-betriebenen mobilen Geräten und Systemen wird die Reduktion der Verlustleistung immer dringlicher. Besonders bei integrierten CMOS-Schaltungen mit vielen Registern, entfällt ein beträchtlicher Anteil der Verlustleistung auf das Umladen der Kapazität des Takt-Knotens oder, bei Systemen mit verteilten Takten, der Taktknoten. Dabei entstehen oftmals zwischen 30 und 50 Prozent der Gesamt-Verlustleistung im Taktsystem.

Die Gesamt-Kapazität des Takt-Knotens setzt sich aus den Gate-Kapazitäten der an den Takt-Knoten angeschlossenen Transistoren und aus den Verdrahtungskapazitäten der Taktleitungen zusammen. Beide Komponenten lassen sich nicht einfach beliebig verkleinern. Selbst immer kleinere Strukturen durch Technologiefortschritte lösen dieses Problem nicht, da zwar die lateralen Dimensionen eines Gates und einer Leitung verkleinert werden, gleichzeitig aber auch die Isolationsschicht dünner wird und die kleineren Lateraldimensionen dazu genutzt werden noch mehr Funktionen auf gegebener Chipfläche unterzubringen. Dazu kommt, daß bei Metallbahnen mit einer Breite in der Größenordnung von 1 µm die Kapazität schon durch die Randkapazität und die Koppelkapazität dominiert und damit fast nur noch von der Länge der Leitung bestimmt wird. Eine Verringerung der Bahnbreite läßt die Randkapazität nahezu unverändert, und reduziert die Gesamtkapazität nicht wesentlich, eine Verringerung des Leiterbahnabstandes erhöht die Koppelkapazität, und damit auch die Gesamtkapazität.

Unter der grundsätzlichen Annahme, daß die Datendurchsatzreate des Systems unverändert bleiben soll, verlangt eine Reduktion der Schaltfrequenz eine erhöhte Komplexität (Parallelisierung), so daß insgesamt keine Einsparung an Verlustleistung zu erzielen ist.

Eine weitere Möglichkeit zur Reduktion der Verlustleistung liegt in der Senkung der Versorgungsspannung der gesamten Schaltung, wobei die Versorgungsspannung in die Verlustleistung sogar quadratisch eingeht aber eine verlustbehaftete Anpassung an übrige Schaltungsteile erforderlich macht und gegebenenfalls eine Verringerung der Störsicherheit bewirkt wird.

Aus der US-Patentschrift 4 563 600 ist eine ECL-Takttreiberschaltung bekannt, bei der ein erster Anschluß einer letzten Stufe der Treiberschaltung mit einer Taktversorgungsspannung versorgt ist, die dem Betrag nach geringer ist als die allgemeine Versorgungsspannung des integrierten Schaltkreises mit dieser Treiberschaltung und bei der ein zweiter Anschluß der letzten Stufe direkt mit Bezugspotential verbunden ist.

Die der Erfindung zugrundeliegende Aufgabe besteht nun darin, eine integrierte Schaltung anzugeben, die ein möglichst gutes Verhältnis zwischen der Reduktion der Gesamtverlustleistung und der damit verbundenen Reduktion der Leistungsfähigkeit und Störunempfindlichkeit aufweist. Diese Aufgabe wird erfindungsgemäß durch die Merkmale des Patentanspruchs 1 gelöst.

Die Erfindung wird im folgenden anhand der Zeichnungen näher erläutert. Dabei zeigt:

Figur 1      eine Treiberstufe

Figur 2      eine weitere Treiberstufe

Figur 3      ein erstes Ausführungsbeispiel des erfindungswesentlichen Schaltungsteils und

Figur 4      ein zweites Ausführungsbeispiel des erfindungsgemäßen Schaltungsteils der verlustarmen integrierten Schaltung.

Unter verlustarmen integrierten Schaltungen sind in diesem Zusammenhang vor allem CMOS-Schaltungen zu verstehen. Hierbei ist insbesondere an CMOS-Schaltungen mit extensivem Pipelining gedacht, da diese eine Reihe von Registern und somit in der Regel auch ein umfangreiches Taktsystem aufweisen.

Die grundlegende Idee liegt in der Verwendung eines Taktgenerators bzw. eines Takttreibers mit verringertem Hub, das heißt, daß die Versorgungsspannung des Takttreibers um den Faktor r gegenüber der allgemeinen Versorgungsspannung reduziert ist. Der grundsätzliche Aufbau des Takttreibers weist hintereinander geschaltete Inverterstufen auf, deren Transistorweiten zum Takttreiberausgang hin zunehmen. Zur Erzielung eines reduzierten Takthubes reicht es aus, wenn nur die letzte Inverterstufe am Takttreiberausgang modifiziert wird.

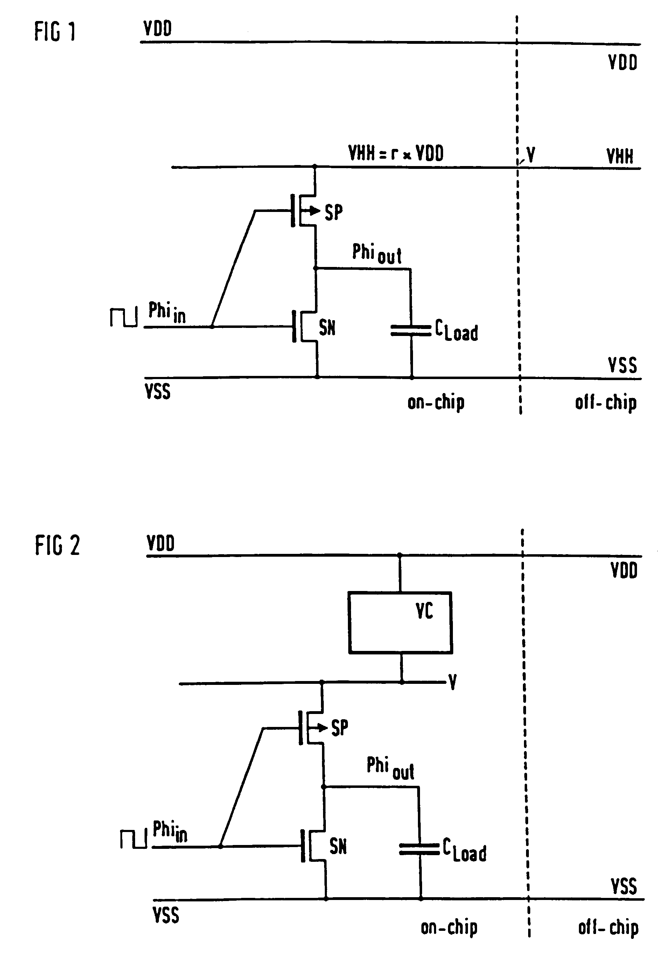

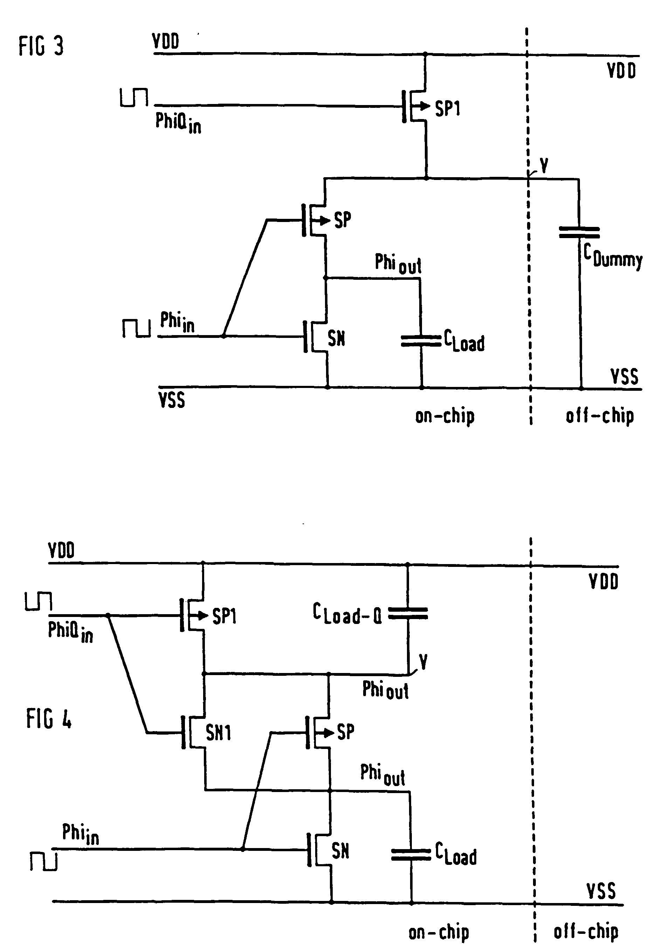

In Figur 1 ist eine Treiberstufe dargestellt. Hierbei sind beispielsweise zwei komplementäre Schalttransistoren SP und SN in Reihe geschaltet, wobei ein erster Anschluß des Transistors SP mit einer extern vorhandenen reduzierten Taktversorgungsspannung VHH und ein erster Anschluß des Transistors SN mit Bezugspotential VSS, die zweiten Anschlüsse der Transistoren SP und SN miteinander verbunden sind und den Gateanschlüssen der Transistoren SP und SN jeweils ein Ausgangssignal $Phi_{in}$ einer vorhergehenden Inverterstufe zugeführt ist. Zwischen der Verbindung der beiden Transistoren SP und SN und Bezugspotential VSS liegt eine Lastkapazität $C_{Load}$ an der das Taktausgangssignal $Phi_{out}$ anliegt. Die externe Taktversorgungsspannung VHH ist um den Faktor r gegenüber der allgemeinen Versorgungsspannung VDD reduziert.

Für Anwendungen mit komplementären Taktphasen sind zwei externe Taktversorgungsspannungen nötig, wenn nicht gerade der Hub im Taktsystem VDD/2 sein soll. Hierbei erfolgt die maximal mögliche Reduktion der Verlustleistung im Taktsystem, wobei eine Re-

duktion um den Faktor r$^2$ auftritt. Weiterhin ist allerdings zu berücksichtigen, daß zur chip-internen Verlustleistung noch die in den Reglern der zusätzlichen externen Spannungsversorgung dazukommt.

In Figur 2 ist eine weitere Treiberstufe dargestellt, die sich nur dadurch von Figur 1 unterscheidet, daß anstelle einer externen Taktversorgung VHH die Taktversorgungsspannung V mit Hilfe eines Spannungsreglers VC erzeugt wird. Der Spannungsregler VC kann dabei beispielsweise aus einem klassischen Längs regler bestehen, wie er beispielsweise bei stabilisierten Netzteilen verwendet wird. Hierbei wird ebenfalls die Verlustleistung in der Takttreiberschaltung um den Faktor r$^2$ reduziert, jedoch muß die zusätzliche Verlustleistung in der Regelschaltung VC, an der die Spannung (1 - r) * VDD abfällt, noch berücksichtigt werden, so daß sich insgesamt nur eine Reduktion um den Faktor r ergibt.

In Figur 3 ist ein erstes Ausführungsbeispiel der Treiberstufe am Ausgang der Takttreiberschaltung dargestellt. Hierbei ist der in Figur 2 dargestellte Regler VC durch einen Schalttransistor SP1 ersetzt, wobei ein erster Anschluß des Transistors SP1 mit der Versorgungsspannung VDD, ein zweiter Anschluß über einen Hilfskondensator $C_{Dummy}$ mit Bezugspotential VSS und der Gateanschluß des Transistors SP1 mit einem zum Takteingangssignal $Phi_{in}$ inversen Taktsignal $PhiQ_{in}$ versorgt wird. Der externe Hilfskondensator $C_{Dummy}$ wird während einer ersten Taktphase aufgeladen, worauf der Schalttransistor SP1 sperrt. In der darauffolgenden Taktphase wird aus dem Hilfskondensator über den pull-up-Transistor SP der Inverterstufe die Lastkapazitat $C_{Load}$ des Takttreibers aufgeladen. Dabei wird der Hub nach folgender Formel bestimmt:

$$V_{High} = VDD \times C_{Dummy} /(C_{Dummy} + C_{Last})$$

Für den speziellen Fall $C_{Dummy} = C_{Last}$ ergibt sich ein Hub im Taktsystem von VDD/2. Die Verlustleistung reduziert sich ebenfalls nur um den Faktor r.

Allein unter dem Aspekt der Verlustleistungsreaktion bietet die Schaltung daher keinen Vorteil gegenüber der Regelschaltung VC in Figur 2.

Die erforderlichen externen Lastkapazitäten stellen in einigen Fällen einen zu hohen Aufwand dar. Andererseits ist es über diese Kapazität möglich den Takthub fast beliebig frei zu wählen, indem nur die externe Beschaltung verändert wird. Außerdem kann das Aufladen der Hilfskapazität über den Schalttransistor SP1 mit einer längeren Zeitkonstante als der im Taktsystem benötigen Flankendauer erfolgen. Konkret heißt das, daß der Schalttransistor zum Aufladen des Hilfskondensators mit einer deutlich kleineren Transistorweite als der pull-up-Transistor SP der Takttreiberendstufe dimensioniert werden kann. Auf diese Weise lassen sich die typischen Stromspitzen im Versorgungssystem für die Spannung VDD, wie sie von konventionellen Takttreibern hervorgerufen werden, mit all ihren problematischen Nebenwirkungen verringern.

In Figur 4 ist eine zweite Ausführungsform der Treiberstufe am Takttreiberausgang dargestellt. Das in Figur 4 dargestellte Ausführungsbeispiel unterscheidet sich von dem Ausführungsbeispiel in Figur 3 dadurch, daß anstelle der Hilfskapazität $C_{Dummy}$ eine weitere Lastkapzitat $C_{Load}$-Q vorgesehen ist, deren zweiter Anschluß nicht mit Bezugspotential VSS, sondern mit der allgemeinen Versorgungsspannung VDD verbunden ist und daß ein zum Schalttransistor SP1 komplementärer Schalttransistor SN1 vorgesehen ist, dessen erster Anschluß mit der Leitung für die reduzierte Taktversorgungsspannung V, dessen zweiter Anschluß mit der Verbindung zwischen den beiden Transistoren SP und SN und dessen Gate mit dem Gate des Transistors SP1 verbunden ist.

Vorteilhafterweise kann hierbei die Taktversorgungsspannung (V) gleichzeitig als ein zum Ausgangssignal $Phi_{out}$ der letzten Stufe inverses Ausgangssignal $PhiQ_{out}$ benutzt werden.

Die Schaltungsvariante nach Figur 4 arbeitet ebenfalls nach dem Prinzip der Ladungsteilung, ohne jedoch einen zusätzlichen externen Kondensator zu benützen. Stattdessen wird die Ladung zwischen den Lastkapazitaten der beiden komplementären Takttreiber SP, SN und SP1, SN1 aufgeteilt. Die Schaltung ist für komplementäre Taktsysteme verwendbar, die im Hinblick auf Verlustleistung wegen der Einsetzbarkeit einfacher Register besonders attraktiv ist. Der Faktor r ist, wie beim Ausführungsbeispiel von Figur 3 durch die Kapazitätsvehältnisse bestimmt. Die Schaltung von Fig. 4 ist jedoch auf den speziellen Fall von r = ca. 0,5 zugeschnitten. Da in diesem Falle keine zusätzlichen Komponenten zur Reduktion der Spannung benutzt werden, sondern die beiden komplementären Treiber gegenseitig füreinander die Rolle des "Vorwiderstandes" übernehmen , ergibt sich hierbei eine Reduktion der Verlustleistung um den Faktor r$^2$. Von allen betrachteten Ausführungsbeispielen ist dies die einzige Variante ohne zusätzliche externe Versorgungsspannungen, bei der die Verlustleistung mit dem Faktor r$^2$, also um den maximalen Verringerungsfaktor, reduziert wird.

Der Reduktionsfaktor r kann prinzipiell im Bereich 0 < r < 1 gewählt werden. Für die Anwendung im integrierten Schaltkreis ist für r ein Bereich von etwa 0,4 bis etwa 0,6 optimal, da hierbei ein günstiges Verhältnis zwischen Verlustleitung und Leistungsfähigkeit bzw. Störempfindlichkeit besteht.

Die Schalttransistoren SP und SP1 bestehen hierbei beispielsweise aus p-Kanal-Feldeffekttransistoren und die Schalttransistoren SN, SN1 aus n-Kanal-Feldeffekttransistoren, können aber beispielsweise auch in Form von entsprechenden npn- und pnp-Transistoren realisiert sein.

Die Verringerung von Signalhüben muß grundsätzlich im Hinblick auf eine eventuelle Verringerung des Störabstandes betrachtet werden. Wenn nur bei wenigen Signalen innerhalb eines Chips der Hub verringert wird, bei ansonsten gleichbleibenden Störleistungen, werden Schaltungsteile an denen diese Signale anliegen störempfindlicher. Daher wird in bekannten Schaltungen dieser Art für alle Signale der volle Hub zwischen VDD und VSS verwendet. Das Taktsystem bildet, insbesondere bei Schaltungen mit extensivem Pipelining, jedoch eine gewisse Ausnahme, da die Taktknoten eine um Größenordnungen höhere Kapazität haben als alle anderen auf dem Chip vorkommenden Signalknoten. Gleichzeitig sind in der Endstufe des Takttreibers die Transistoren um Größenordnungen breiter dimensioniert als in einem normalen Ausgang eines Gatters, das irgendein Signal treibt. Das Taktsystem hat damit eine um Größenordnungen niedrigere Impedanz als alle anderen Signalleitungen am Chip. Damit ist das Taktsignal auch nicht so leicht durch eine parasitäre Einkopplung zu stören, wie zum Beispiel irgendeine andere Signalleistung. Dazu kommt daß Signalnetze, die sich sehr weit über den Chip ausbreiten, wie das auch speziell für Taktnetze zutrifft, mit sehr vielen anderen Signalen gekoppelt sind. Wenn davon ausgegangen wird, daß diese Signale nicht alle gleichzeitig in eine Richtung umschalten wird im Mittel die Summe aller dieser Einkopplungen sehr klein sein, und im Grenzwert gegen Null gehen. Diese Annahme der statistisch gleichmäßigen Verteilung ist in normalen integrierten Schaltungen dieser Art durchaus gerechtfertigt. Bei vollständig dynamischen logischen Schaltungen mit Vorlade-Strategien, wie sie hier nicht betrachtet werden sollen, gilt diese Annahme natürlich nicht mehr. Bei den üblichen integrierten Schaltungen dieser Art ist also die Einkopplung von Signalen auf die Leitungen des Takt systems nicht sehr gravierend.

Bei integrierten Schaltungen mit Registern erhöht sich durch die Verringerung des Signalhubs im allgemeinen die Schaltzeit. Ohne eine Umdimensionierung der Register wird bei einem Reduktionsfaktor r = 0,5 die maximale Schaltfrequenz um 60 Prozent und die Verlustleistung im Taktnetz um 75 Prozent reduziert. Die Abwagung von Schaltfrequenz und Verlustleistungseinsparung scheint auf den ersten Blick nicht besonders vorteilhaft, es ist jedoch zu berücksichtigen, daß bei vielen Anwendungen die maximale Taktfrequenz des Systems nicht durch die Schaltgeschwindigkeit der Register, sondern durch kritische Pfade in Logik-Blöcken bestimmt wird.

Durch eine Umdimensionierung der Register für Fälle, in denen eine Reduktion der Schaltgeschwindigkeit der Register um 60 Prozent nicht akzeptabel erscheint, wenn beispielsweise die Datendurchsatzrate verringert würde, kann die Schaltgeschwindigkeit der Register durch Umdimensionierung der vom Takt angesteuerten Transistoren angepaßt werden. Um mit einem um den Faktor r = 0,5 reduzierten Takthub die gleiche Geschwindigkeit zu erreichen wie im Falle des nicht reduzierten Hubs, müssen die Transistorweiten der vom Takt angesteuerten Transistoren etwa um den Faktor 2 erhöht werden. Damit erhöht sich die Gesamtkapazität des Taktsystems. Da aber die Verdrahtungskapazitäten deutlich höher sind als die sich durch die Transistorgates ergebende Kapazität, ändert sich die Gesamtkapazität des Taktsystems nur wenig. Daher kann sich die bei einer Umdimensionierung der Register ergebende Verlustleistungseinsparung im Taktsystem immer noch auf bis zu 70 Prozent belaufen.

## Patentansprüche

1. Integrierte Schaltungsanordnung mit einer Takttreiberschaltung, bei der mindestens eine letzte Stufe der Takttreiberschaltung (SP, SN) mit einer Taktversorgungsspannung (V) versorgt ist, die dem Betrag nach geringer ist als eine allgemeine Versorgungsspannung (VDD) des integrierten Schaltkreises, **dadurch gekennzeichnet**, daß ein Schalttransistor (SP1) vorhanden ist, dessen erster Anschluß mit der allgemeinen Versorgungsspannung (VDD), dessen zweiter Anschluß mit der Taktversorgungsspannung (V) verbunden sind und dessen Gateanschluß mit einem zum Takteinangssignal ($Phi_{in}$) der letzten Stufe (SP, SN) inversen Taktsignal ($PhiQ_{in}$) versorgt ist, und daß der zweite Anschluß des Schalttransistors (SP1) über eine Hilfskapazität ($C_{Dummy}$) mit Bezugspotential (VSS) verbunden ist.

2. Integrierte Schaltungsanordnung mit einer Takttreiberschaltung, bei der mindestens eine letzte Stufe der Takttreiberschaltung (SP, SN) mit einer Taktversorgungsspannung (V) versorgt ist, die dem Betrag nach geringer ist als eine allgemeine Versorgungsspannung (VDD) des integrierten Schaltkreises, **dadurch gekennzeichnet**, daß eine Inverterstufe (SP1, SN1) vorhanden ist, die mit der Differenzspannung zwischen dem Ausgang der letzten Stufe (SP,SN) und der allgemeinen Versorgungsspannung (VDD) versorgt ist, die mit einem zum Takteingangssignal ($Phi_{in}$) der letzten Stufe inversen Takteingangssignal ($PhiQ_{in}$) angesteuert ist und deren Ausgang über eine Kapazität ($C_{Load-Q}$) mit der allgemeinen Versorgungsspannung verbunden ist und die Taktversorgungsspannung (V) für die letzte Treiberstufe (SP, SN) liefert.

## Claims

1. Integrated circuit arrangement having a clock driver circuit, in which at least a last stage of the clock driver circuit (SP, SN) is supplied with a clock supply voltage (V), the magnitude of which is less than a general supply voltage (VDD) of the integrated circuit, characterized in that a switching transistor (SP1) is present, whose first terminal is connected to the general supply voltage (VDD), whose second terminal is connected to the clock supply voltage (V) and whose gate terminal is supplied with a clock signal (PhiQ$_{in}$) which is the inverse of the clock input signal (Phi$_{in}$) of the last stage (SP, SN), and in that the second terminal of the switching transistor (SP1) is connected to reference-earth potential (VSS) via an auxiliary capacitor (C$_{Dummy}$).

2. Integrated circuit arrangement having a clock driver circuit, in which at least a last stage of the clock driver circuit (SP, SN) is supplied with a clock supply voltage (V), the magnitude of which is less than a general supply voltage (VDD) of the integrated circuit, characterized in that an inverter stage (SP1, SN1) is present, which is supplied with the difference voltage between the output of the last stage (SP, SN) and the general supply voltage (VDD), which is driven with a clock input signal (PhiQ$_{in}$) that is the inverse of the clock input signal (Phi$_{in}$) of the last stage and whose output is connected to the general supply voltage via a capacitor (C$_{Load-Q}$) and delivers the clock supply voltage (V) for the last driver stage (SP, SN).

## Revendications

1. Disposition intégrée de circuits avec commutation par circuit de commande d'horloge, dans laquelle au moins un dernier étage du circuit de commande d'horloge (SP, SN) est alimenté par une tension d'alimentation d'horloge (V) dont la valeur est plus faible qu'une tension d'alimentation générale (VDD) du circuit intégré, caractérisée en ce qu'un transistor de commutation (SP1) est présent, dont la première connexion est reliée à la tension d'alimentation générale (VDD), dont la deuxième connexion est reliée à la tension d'alimentation d'horloge (V), et dont la connexion de grille est alimentée par un signal d'horloge (PhiQ$_{in}$) inverse du signal d'entrée d'horloge (Phi$_{in}$) du dernier étage (SP, SN), et en ce que la deuxième connexion du transistor de commutation (SP1) est reliée au potentiel de référence (VSS) par une capacité auxiliaire (C$_{Dummy}$).

2. Disposition de circuits intégrés avec commutation par circuit de commande d'horloge, dans laquelle au moins un dernier étage du circuit de commande d'horloge (SP, SN) est alimenté par une tension d'alimentation d'horloge (V) dont la valeur est plus faible qu'une tension d'alimentation générale (VDD) du circuit intégré, caractérisée en ce qu'un étage inverseur (SP1, SN1) est présent, qui est alimenté par la tension différentielle qui existe entre la sortie du dernier étage (SP, SN) et la tension d'alimentation générale (VDD), qui est commandé par un signal d'entrée d'horloge (PhiQ$_{in}$) inverse du signal d'entrée d'horloge (Phi$_{in}$) du dernier étage, et dont la sortie est reliée par une capacité (C$_{Load-Q}$) à la tension d'alimentation générale, et qui délivre la tension d'alimentation d'horloge (V) pour le dernier étage de commande (SP, SN).

FIG 1

VDD

VDD

$VHH = r \times VDD$    V    VHH

SP

Phi$_{out}$

Phi$_{in}$

SN

C$_{Load}$

VSS

VSS      on-chip      off-chip

FIG 2

VDD

VDD

VC

V

SP

Phi$_{out}$

Phi$_{in}$

SN

C$_{Load}$

VSS

VSS      on-chip      off-chip

6

FIG 3

FIG 4